# EUROPEAN PATENT SPECIFICATION

(11) **EP 1 853 102 B1**
(45) Date of publication and mention of the grant of the patent: **18.01.2012**
(21) Application number: 07104845.8
(22) Date of filing: 26.03.2007
(51) Int. Cl.: H05K 7/20

(54) **Apparatus for conditioning racks for electrical, electronic and telecommunications instruments and the like**
Vorrichtung zum Konditionieren von Gestellen für elektrische, elektronische und Telekommunikationsinstrumente und dergleichen
Appareil de conditionnement de panier pour instruments électriques, électroniques et de télécommunication et similaires

(30) Priority: 05.05.2006 IT PD20060176
(43) Date of publication of application: 07.11.2007
(73) Proprietor: Emerson Network Power S.R.L., 35028 Piove di Sacco (PD) (IT)
(72) Inventor: Scattolin, Mario, 30037, Scorze' VE (IT); Ranzato, Alberto, 35028, Piove Di Sacco PD (IT); Girotto, Carlo, 35020, Masera' PD (IT)
(74) Representative: Modiano, Micaela Nadia

(56) References cited:
- DE-C1- 10 210 658
- DE-U1- 8 807 768
- US-A1- 2004 148 948
- US-A1- 2004 217 072

## Description

The present invention relates to an apparatus for conditioning racks for electrical, electronic and telecommunications instruments or the like.

Together with computers and the use of internal and external data communications networks (the Internet, intranets and the like), supporting chassis for the electrical and electronic instruments and the like which form said computers (servers, auxiliary memories and the like) and define the nodes of such networks (routers and the like), on which these devices can be installed and interfaced in a small space, are increasingly widespread.

Chassis adapted for this purpose are known as racks, and are widespread for example in the field of mobile telephone network sites.

The racks are generally arranged within cabinets, protected against dust and external agents in general.

The main problem linked to racks and to the cabinets which contain them relates to the overheating of the electronic instruments enclosed in the cabinet, especially since the increasing growth of mobile telephony and of other sectors of electronics and computing, has led to an increase in the number of instruments supported by a same rack and packed within a same cabinet.

Problems therefore arise which are linked to the dissipation of the heat generated within the cabinet by such instruments and therefore to the appropriate conditioning of said cabinets.

For example, the increase in the number of racks within a GSM/GPRS network site and the birth of the UMTS network, characterized by greater heat dispersion, has necessarily modified the conditioning requirements in recent years.

An excessive increase in temperature can in fact cause malfunctions of various kinds, to the point of failure of the instruments contained in the cabinet.

Currently, the heat dissipation for such rack cabinets is entrusted to the conditioning system of the room in which the cabinet is located and to the slots or grilles of the cabinet which are adapted to allow the passage of air which arrives from the room among the instruments supported by the rack (or racks) contained in said room.

This cooling method is generally insufficient, especially in the presence of the extremely compact new-generation servers, which generate extremely high power consumptions per unit volume.

Accordingly, regions which are stably too hot (so-called "hot spots") thus form inside the rack cabinet and locally cause problems to electrical and electronic instruments up to failure.

In order to obviate these drawbacks, this same Applicant has devised a conditioning apparatus which is disclosed and claimed in European Patent Application No. 05110402.4 of November 7, 2005.

This apparatus, particularly for racks for electrical, electronic, telecommunications instruments or the like, is characterized in that it is constituted by at least one cabinet, which is formed by at least one door for accessing its interior, two side walls and a back wall, said cabinet containing a rack chassis for supporting electronic devices and the like; air passage gaps are formed between the at least one door and the rack chassis and the back and said rack chassis; the cabinet is open in an upper region onto a first air conveyance element and in a lower region onto a second air conveyance element, said first and second elements being in turn connected respectively to third and fourth conveyance elements, which are arranged above and below an air-conditioning module, which is laterally adjacent to the cabinet and is adapted to draw warm air from it and inject refrigerated air therein.

Such apparatus can be configured advantageously so as to comprise an alternating series of cabinets and conditioning units and so as to have one extra conditioning unit with respect to the number of rack cabinets, a redundancy which increases significantly the reliability of the apparatus as a whole.

Although this apparatus fully achieves the aim of conditioning the rack chassis and the instruments which it supports, it does not have a safety system which allows to cool the racks even in extreme emergency conditions, such as in the case of simultaneous malfunction of all the air-conditioning modules, a contingency which cannot be tolerated when correct operation for example of servers, routers and electronic devices linked to mobile telephony is at stake.

The aim of the present invention is to provide a conditioning apparatus for racks for electrical, electronics and telecommunications instruments and the like which is capable of ensuring the cooling of the electronic instruments contained therein even in case of malfunction of all the air-conditioning modules.

Within this aim, an object of the present invention is to provide an apparatus which, if it has a plurality of rack cabinets, is capable of conditioning them all even in case of failure of any one of the conditioning modules which belong to said apparatus.

A further object of the present invention is to provide an apparatus which can be easily configured for a plurality of rack cabinets arranged close to each other.

Another object of the present invention is to provide an apparatus by way of which it is possible to modulate the flow-rate of the air and change its path for always optimum cooling of the involved racks.

Another object of the present invention is to provide a conditioning apparatus which prevents the formation of regions which are stably too hot inside a rack cabinet.

Another object of the present invention is to provide a conditioning apparatus for racks for electrical, electronic, and telecommunications instruments and the like which can be manufactured cheaply with known systems and technologies.

This aim and these and other objects which will become better apparent hereinafter are achieved by a conditioning apparatus for racks for electrical, electronic and telecommunications instruments and the like, of the type which comprises at least one cabinet formed by at least one door for accessing its interior, two side walls and a back wall, and inside which there is a rack chassis for supporting electronic devices and the like, air passage gaps being formed between said at least one door and said rack chassis and between said back and said rack chassis, said cabinet being open in an upper region onto a first air conveyance element and in a lower region onto a second air conveyance element, said first and second elements being in turn connected respectively to at least one third and one fourth conveyance elements, which are arranged above and below at least one associated air-conditioning module which is laterally adjacent to said cabinet and is adapted to draw warm air from it in order to inject refrigerated air therein, said apparatus being characterized in that at least one of two adjacent conveyance elements has at least one first shutter which is adapted to allow, modulate or inhibit the circulation of air between said two adjacent conveyance elements, said first and second conveyance elements associated with the cabinet being each provided with a second shutter for conditioning of the free cooling type of the interposed cabinet, at least one of said first and second conveyance elements being provided with ventilation means for forced circulation of the ambient air inside said interposed cabinet.

Further characteristics and advantages of the invention will become better apparent from the following detailed description of a preferred but not exclusive embodiment thereof, illustrated by way of non-limiting example in the accompanying drawings, wherein:
Figure 1 is a schematic front view of an apparatus according to the invention;
Figure 2 is a schematic side view of the path of the air inside a rack cabinet which belongs to the apparatus according to the invention in a first or second operating mode;
Figure 3 is a perspective view of a cabinet of the apparatus according to the invention;
Figure 4 is a perspective view of a conditioning module of the apparatus according to the invention;
Figure 5 is a perspective view of a detail of the apparatus according to the invention;
Figure 6 is a schematic front view of the apparatus according to the invention in a second embodiment thereof and in a first operating mode;
Figure 7 is the same front view as Figure 6, with the apparatus according to the invention in a second operating mode;
Figure 8 is a schematic side view of the path of the air inside a rack cabinet which belongs to the apparatus according to the invention in a third operating mode;
Figure 9 is the same front view as Figures 6 and 7, with the apparatus according to the invention in a third operating mode;
Figure 10 is a partially exploded perspective view of a detail of an upper conveyance element of a cabinet of the apparatus according to the invention;
Figure 11 is a partially exploded perspective view of a detail of a lower conveyance element of a cabinet of the apparatus according to the invention.

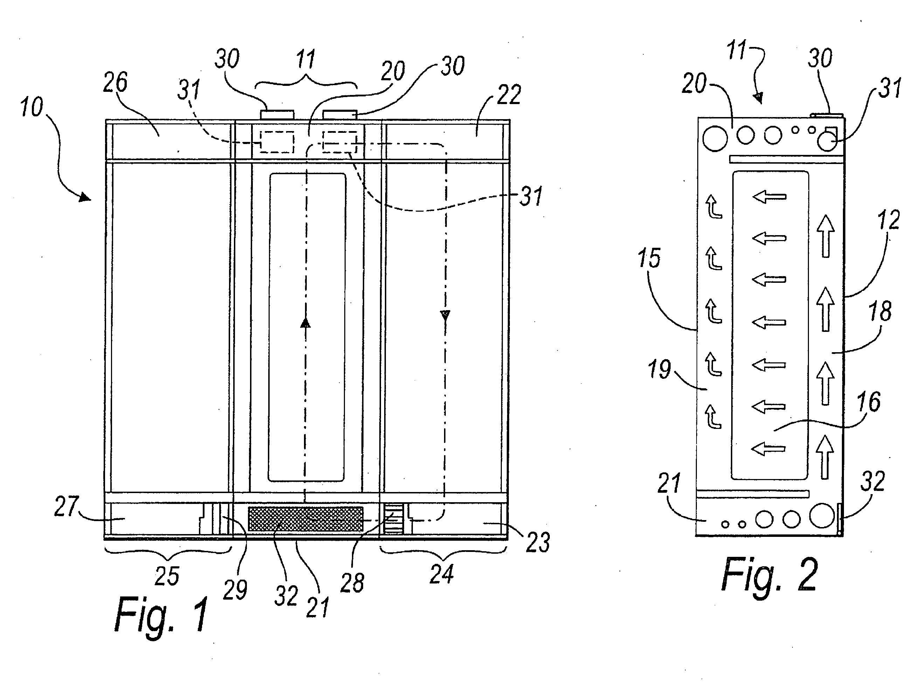

With reference to the figures, a conditioning apparatus for racks for electrical, electronic and telecommunications instruments and the like according to the invention is generally designated by the reference numeral 10 in its first exemplifying and non-limiting embodiment, which is shown in Figure 1.

The apparatus 10 comprises, in the embodiment of Figure 1, a cabinet 11 which is formed by a door 12 for accessing its interior, two side walls 13 and 14, and a back 15, and inside which there is a rack chassis 16 for supporting electronic devices or instruments and the like 17.

Air passage gaps 18 and 19 respectively are formed between the door 12 and the rack chassis 16 and between the back 15 and the rack chassis 16.

The cabinet 11 is open in an upper region onto a first air conveyance element 20 and in a lower region onto a second air conveyance element 21.

The first and second elements 20, 21 are in turn connected respectively to a third conveyance element 22 and a fourth conveyance element 23, which are arranged above and below an associated first air-conditioning module 24 which is laterally adjacent to the cabinet 11; the conditioning module 24 is designed to draw warm air from the cabinet 11 and inject refrigerated air therein.

The apparatus 10 also comprises a second air-conditioning module 25, which is laterally adjacent to the cabinet 11 on the opposite side with respect to the first module 24.

The second module 25 has a fifth upper air conveyance element 26 and a sixth lower air conveyance element 27, which are connected to the adjacent conveyance elements 20 and 21 of the cabinet 11.

The lower conveyance elements 23 and 27 of the two conditioning modules 24 and 25 are each provided, in this first embodiment of the apparatus according to the invention, with a first shutter 28 and 29 respectively, which is adapted to allow, modulate or inhibit the circulation of air between said conveyance elements 23 or 27 and the lower conveyance element 21 of the cabinet 11.

The first shutters 28 and 29, of a per se known type, are made of plastic or metallic material, and their configuration, i.e., their degree of opening, is managed by electromechanical actuators, of a per se known type and not shown, which in turn are managed by a central unit for controlling the entire apparatus 10.

The first conveyance element 20 and the second conveyance element 21 associated with the cabinet 11 are each provided with at least one additional shutter for conditioning of the free-cooling type of the interposed cabinet 11, at least one of said first and second conveyance elements 20, 21 being provided with ventilation means for forced circulation of the ambient air within the cabinet 11.

In said first exemplifying and non-limiting embodiment of the invention, the first conveyance element 20 is provided with two second upper shutters 30, each of which is arranged at a part of the ventilation means arranged within the first conveyance element 20.

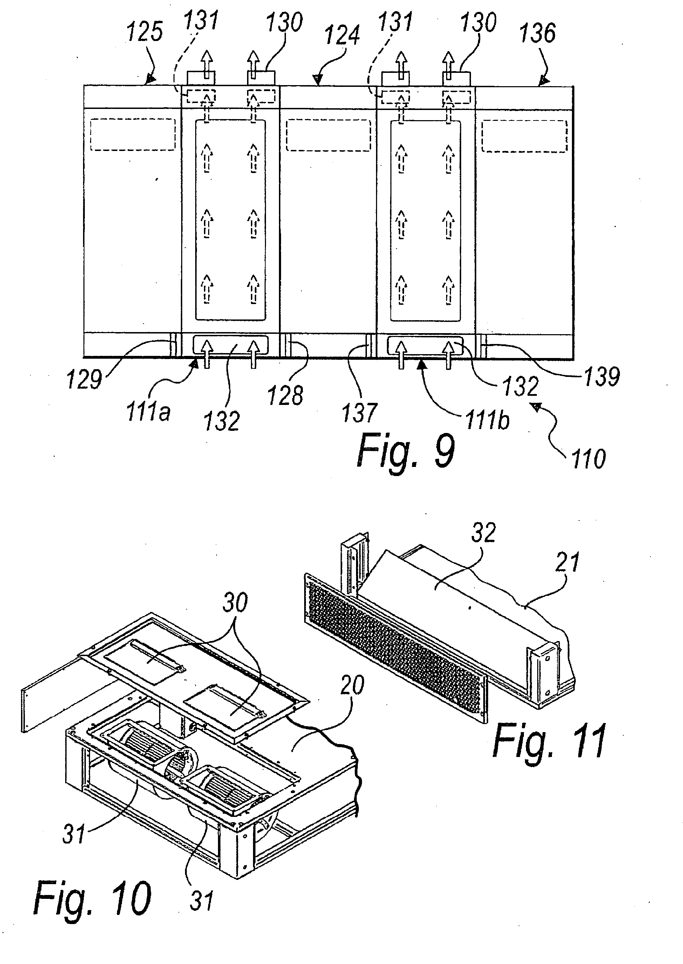

The ventilation means are constituted by two emergency fans 31, which are clearly visible in the partially exploded view of Figure 10.

The second upper shutters 30 can be made of metallic or plastic material and can be selectively motorized or gravity-operated.

In said first exemplifying and non-limiting embodiment of the invention, the second conveyance element 21 has a third lower and front shutter 32, also of the motorized or gravity-operated type, which is made of plastic or metallic material.

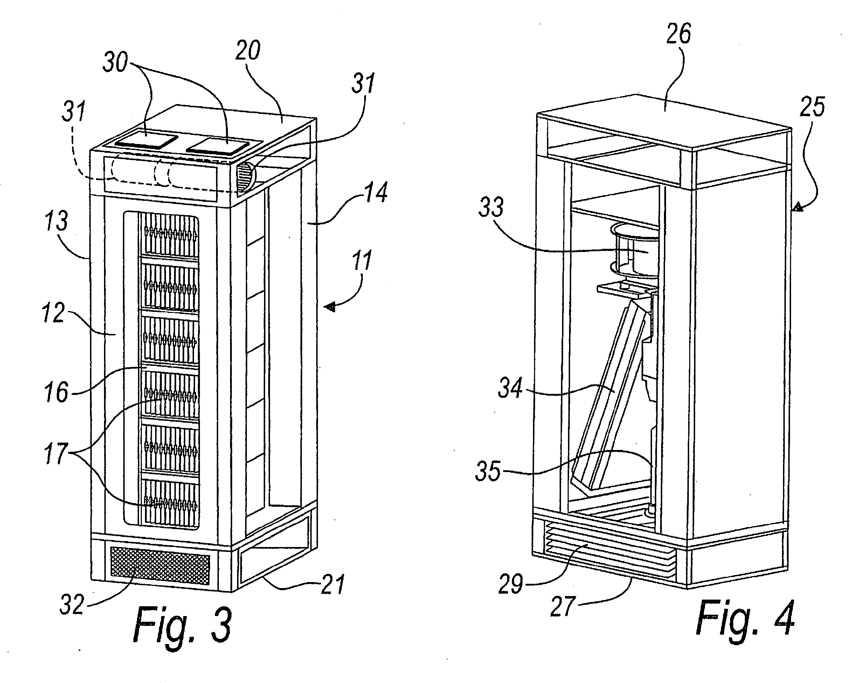

The conditioning module 24 or 25 contains internally, as exemplified for the module 25 in Figure 4, a fan 33, an evaporator 34 and a compressor 35.

The upper conveyance elements 20, 22 and 26 are each constituted by a plenum which is connected to the adjacent upper conveyance element, so as to form an air intake manifold on the inside of the cabinet 11 toward the conditioning module 24 or 25.

The lower conveyance elements 21, 23 and 27 are each constituted by a footing panel for resting on the ground, which is connected to an adjacent lower conveyance element by means of a first shutter, said footing panels forming an additional manifold for introducing conditioned air from the active conditioning module to the cabinet 11.

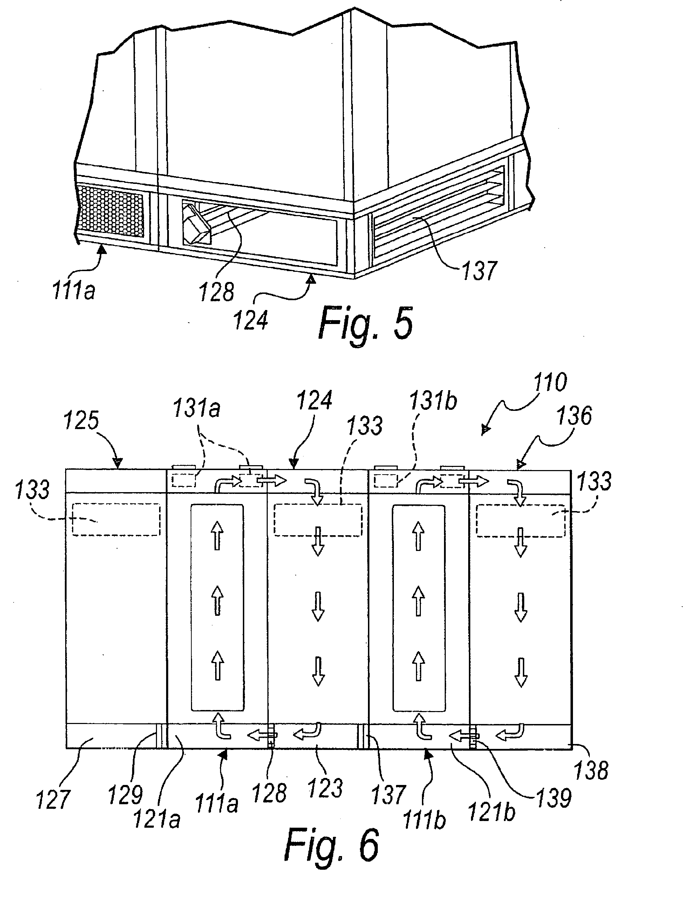

The second embodiment of the apparatus, shown in Figures 5 to 9 and designated generally by the reference numeral 110 therein, comprises, as shown by the diagram of Figure 6, two rack cabinets 111a and 111b, respectively, and three conditioning modules, a first central module 124 and a second module 125 and a third module 136 which are external.

The figures show schematically in broken lines the emergency fans 131a and 131b of the cabinets 111a and 111b and the fans 133 of the conditioning modules.

The apparatus 110 therefore comprises two cabinets 111a and 111b and two conditioning modules, plus one redundant one; this embodiment is to be considered merely an example, since in general the apparatus according to the invention is understood to be composed of N cabinets and (N +1) conditioning modules.

A footing panel 127 of the second external conditioning module 125 has a single first shutter 129, which in Figure 6 is shown schematically in the closed condition, and the corresponding conditioning module 125 is inactive.

A footing panel 123 of the first central conditioning module 124 is provided with two first shutters 128 and 137, each for adjusting the passage of air alternately toward one or the other of the adjacent footing panels 121a or 121b of the adjacent cabinets; in Figure 6, the first left shutter 128 is shown schematically open, while the first right shutter 137 is shown schematically closed.

A footing panel 138 of the third conditioning module 136 has a single first shutter 139, which is shown schematically open.

In said first operating mode of the apparatus 110, the first cabinet 111a is cooled by the first central conditioning module 124, the second cabin 111b is cooled by the third module 136, and the second module 125 is switched off or in standby.

Figure 5 illustrates by way of example the two shutters 128 and 137 of the first module 124.

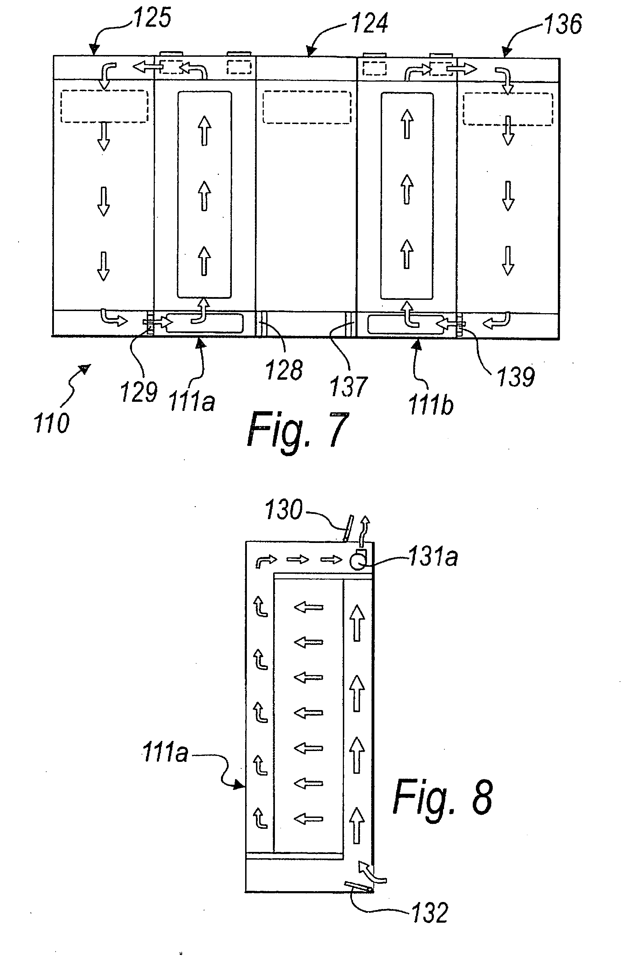

In Figure 7, the apparatus 110 is shown schematically as operating in a second mode.

Said second mode entails that the first shutters 129 and 139 respectively of the second module 125 and of the third module 136 are open, while the first shutters of the first central module 124 are both closed.

Said second mode therefore connects the first cabinet 111a to the second module 125 and the second cabinet 111b to the third module 136, while the first central module 124 is switched off or in standby.

The configuration of the apparatus according to the invention with N cabinets and N+1 modules allows to always have one conditioning module in standby available to be connected to a cabinet which is in critical conditions due to the malfunction of the conditioning module associated therewith at that time, and allows to reduce the workload of each conditioning module by alternately placing in standby, at regular intervals, one after the other, all the conditioning modules or at least some of them.

Figure 9 illustrates a third operating mode of the apparatus 110 according to the invention.

Said third emergency mode entails that the three conditioning modules 124, 125 and 136 are inoperative for any reason and the respective first shutters 128 and 137, 129 and 139 are all closed.

In this situation, the cooling of the cabinets 111a and 111b is ensured by the emergency fans 131, simultaneously with the activation of which the second shutters 130 and third shutters 132 are opened.

In this mode, the cabinets 111a and 111b, isolated from the nearby inactive conditioning modules, are crossed from the bottom upward by ambient air, which passes through them along the path shown schematically in Figure 8.

Said third operating mode can be started manually or automatically by the electronic control unit of the apparatus 110.

The emergency fans 131a and 131b are powered by uninterruptible power supplies (UPS), which are internal or external to the rack cabinet, so as to make the system independent of any electric power outages.

In practice it has been found that the invention thus described solves the problems noted in known types of conditioning apparatus for racks for electrical, electronic and telecommunications instruments and the like.

In particular, the present invention provides a conditioning apparatus for racks for electrical, electronic and telecommunications instruments and the like which is capable of ensuring the cooling of the electronic instruments contained therein even in case of malfunction of all the air-conditioning modules, thanks to the emergency fans 31 and 13a and 13b which are installed in the upper conveyance elements of the cabinets and to the corresponding associated shutters.

Further, the present invention provides an apparatus which, if it is provided with a plurality of rack cabinets, can condition them all even if any one of the conditioning modules that belong to the apparatus fails, thanks to the modification of the air passage paths allowed by the shutters with which the conditioning modules and the cabinets are provided.

Moreover, the present invention provides an apparatus which can be installed easily for a plurality of rack cabinets arranged in the vicinity of each other.

Further, the present invention provides an apparatus by way of which it is possible to modulate the air flow-rate and change its path for an always optimum cooling of the involved racks.

Moreover, the present invention provides an apparatus for conditioning racks for electrical, electronic and telecommunications instruments and the like which can be manufactured cheaply with known systems and technologies.

In practice, the materials employed, so long as they are compatible with the specific use, as well as the dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A conditioning apparatus for racks for electrical, electronic and telecommunications instruments and the like, of the type which comprises at least one cabinet (11) formed by at least one door (12) for accessing its interior, two side walls (13, 14) and a back wall (15), and inside which there is a rack chassis (16) for supporting electronic devices and the like (17), air passage gaps (18, 19) being formed between said at least one door (12) and said rack chassis (16) and between said back (15) and said rack chassis (16), said cabinet (11) being open in an upper region onto a first air conveyance element (20) and in a lower region onto a second air conveyance element (21), said first and second elements (20, 21) being in turn connected respectively to at least one third (22, 26) and one fourth (23, 27) conveyance elements, which are arranged above and below at least one associated air-conditioning module (24, 25) which is laterally adjacent to said cabinet (11) and is adapted to draw warm air from it in order to inject refrigerated air therein, said apparatus being **characterized in that** at least one of two adjacent conveyance elements (20, 21, 22, 23, 26, 27) has at least one first shutter (28, 29) which is adapted to allow, modulate or inhibit the circulation of air between said two adjacent conveyance elements (20, 21, 22, 23, 26, 27), said first and second conveyance elements (20, 21) associated with the cabinet (11) being each provided with at least one second upper shutter (30) and at least one third lower front shutter (32) for conditioning of the free cooling type of the interposed cabinet (11), at least one of said first and second conveyance elements (20, 21) being provided with ventilation means for forced circulation of the ambient air inside said interposed cabinet (11).

2. The apparatus according to claim 1, **characterized in that** it comprises a first air-conditioning module (24) and a second air-conditioning module (25), which is laterally adjacent to the cabinet (11) on the opposite side with respect to the first module (24).

3. The apparatus according to claims 1 and 2, **characterized in that** said first (20) and second (21) conveyance elements of said cabinet (11) are connected respectively to a third conveyance element (22) and a fourth conveyance element (23), which are arranged above and below an associated first air-conditioning module (24), said second module (25) having a fifth upper air conveyance element (26) and a sixth lower air conveyance element (27), which are connected to the adjacent conveyance elements (20, 21) of the cabinet (11).

4. The apparatus according to one or more of the preceding claims, **characterized in that** said lower conveyance elements (23, 27) of the two conditioning modules (24, 25) are each provided with a first shutter (28, 29) which is adapted to allow, modulate or inhibit air circulation between said conveyance elements (23, 27) and the lower conveyance element (21) of the cabinet (11).

5. The apparatus according to claim 4, **characterized in that** said first shutters (28, 29) are made of plastic or metallic material and their configuration, i.e., their degree of opening, is managed by electromechanical, mechanical or equivalent actuators, which in turn are managed by a central control unit for all of the apparatus (10).

6. The apparatus according to one or more of the preceding claims, **characterized in that** said first conveyance element (20) has two second upper shutters (30), each of which is arranged at a part of the ventilation means, which are arranged within said first conveyance element (20).

7. The apparatus according to one or more of the preceding claims, **characterized in that** said ventilation means are constituted by a pair of emergency fans (31).

8. The apparatus according to one or more of the preceding claims, **characterized in that** said second upper shutters (30) are made of metallic or plastic material or other equivalent material.

9. The apparatus according to one or more of the preceding claims, **characterized in that** said second shutters (30) are selectively motorized or gravity-operated.

10. The apparatus according to one or more of the preceding claims, **characterized in that** said second conveyance element (21) has a third lower shutter (32), of the motorized or gravity-operated type, made of plastic or metallic material.

11. The apparatus according to one or more of the preceding claims, **characterized in that** said upper conveyance elements (20, 22, 26) are each constituted by a plenum which is connected to the adjacent upper conveyance element so as to form a manifold for drawing the air from the inside of the cabinet (11) toward a conditioning module (24, 25).

12. The apparatus according to one or more of the preceding claims, **characterized in that** said lower conveyance elements (21, 23, 27) are each constituted by a footing panel which rests on the ground and is connected to an adjacent lower conveyance element by means of a first shutter, said footing panels forming an additional manifold for introducing conditioned air from the active conditioning module into the cabinet (11).

13. The apparatus according to one or more of the preceding claims, **characterized in that** it comprises N rack cabinets and N+1 conditioning modules.

14. The apparatus according to one or more of the preceding claims, **characterized in that** it comprises two rack cabinets (111 a, 11b) and three conditioning modules, a first central one (124), and a second one (125) and a third one (136) which are external.

15. The apparatus according to claim 14, **characterized in that** the footing panel (127) of the second external conditioning module (125) has a single first shutter (129).

16. The apparatus according to claims 14 and 15, **characterized in that** the footing panel (123) of the first central conditioning module (124) is provided with two first shutters (128, 137), each for adjusting the air passage alternately toward one or the other of the adjacent footing panels (121a, 121b) of the adjacent cabinets (111a, 111b).

17. The apparatus according to one or more of claims 14 to 16, **characterized in that** the footing panel (138) of the third conditioning module (136) has a single first shutter (139).

18. The apparatus according to one or more of the preceding claims, **characterized in that** said emergency fans (131a, 131b) are powered by uninterruptible power supplies which are internal or external with respect to the rack cabinet so as to render the apparatus (110) independent of any electric power outages.

## Patentansprüche

1. Vorrichtung zum Konditionieren von Gestellen für elektrische, elektronische und Telekommunikationsinstrumente und dergleichen, des Typs, welcher mindestens ein Gehäuse (11) aufweist, das durch mindestens eine Tür (12) für den Zugang in sein Inneres, zwei Seitenwände (13, 14) und eine Rückwand (15) gebildet ist, und innerhalb dessen sich ein Gestellchassis (16) zum Tragen elektronischer Geräte und dergleichen (17) befindet, wobei Luftdurchgangsspalte (18, 19) zwischen der mindestens einen Tür (12) und dem Gestellchassis (16) und zwischen der Rückwand (15) und dem Gestellchassis (16) gebildet sind, wobei das Gehäuse (11) in einem oberen Bereich zu einem ersten Luftführungselement (20) und in einem unteren Bereich zu einem zweiten Luftführungselement (21) hin offen ist, wobei das erste und zweite Element (20, 21) wiederum jeweils mit mindestens einem dritten (22, 26) und einem vierten (23, 27) Führungselement verbunden sind, welche oberhalb und unterhalb mindestens eines zugehörigen Konditionierungsmoduls (24, 25) angeordnet sind, welches seitlich dem Gehäuse (11) benachbart ist und dazu angepasst ist, warme Luft aus diesem abzusaugen, um gekühlte Luft in dieses einzublasen,
wobei die Vorrichtung **dadurch gekennzeichnet ist, dass** mindestens eines von zwei benachbarten Führungselementen (20, 21, 22, 23, 26, 27) mindestens einen ersten Verschluss (28, 29) hat, welcher dazu angepasst ist, die Luftzirkulation zwischen den zwei benachbarten Führungselementen (20, 21, 22, 23, 26, 27) zu ermöglichen, zu modulieren oder zu unterbinden, wobei das zu dem Gehäuse (11) gehörende erste und zweite Führungselement (20, 21) jeweils mit mindestens einem zweiten oberen Verschluss (30) und mindestens einem dritten unteren Frontverschluss (32) versehen ist, um den zur freien Kühlung genutzten Typ des zwischengesetzten Gehäuses (11) zu konditionieren, wobei mindestens eines der ersten und zweiten der Führungselemente (20, 21), mit Ventilationsmitteln zur verstärkten zirkulation der Umgebungsluft innerhalb des zwischengesetzten Gehäuses (11) versehen ist.

2. Vorrichtung nach Anspruch 1, **dadurch gekennzeichnet, dass** sie ein erstes Luftkonditionierungsmodul (24) und ein zweites Luftkonditionierungsmodul (25) umfasst, welches seitlich benachbart dem Gehäuse (11) auf der entgegengesetzten Seite in Bezug auf das erste Modul (24) ist.

3. Vorrichtung nach Anspruch 1 und 2, **dadurch gekennzeichnet, dass** das erste (20) und das zweite (21) Führungselement des Gehäuses (11) jeweils mit einem dritten Führungselement (22) und einem vierten Führungselement (23) verbunden sind, welche oberhalb und unterhalb eines zugehörigen ersten Konditionierungsmoduls (24) angeordnet sind, wobei das zweite Modul (25) ein fünftes oberes Luftführungselement (26) und ein sechstes unteres Luftführungselement (27) hat, welche mit den benachbarten Führungselementen (20, 21) des Gehäuses (11) verbunden sind.

4. Vorrichtung nach einem oder mehreren der vorhergehenden Ansprüche, **dadurch gekennzeichnet, dass** die unteren Führungselemente (23, 27) der beiden Konditionierungsmodule (24, 25) jeweils mit einem ersten Verschluss (28, 29) versehen sind, welcher dazu angepasst ist, die Luftzirkulation zwischen den Führungselementen (23, 27) und dem unteren Führungselement (21) des Gehäuses (11) zu ermöglichen, zu modulieren oder zu unterbinden.

5. Vorrichtung nach Anspruch 4, **dadurch gekennzeichnet, dass** die ersten Verschlüsse (28, 29) aus Kunststoff- oder metallischem Material bestehen und deren Anordnung, d. h. deren Öffnungsgrad, durch elektromechanische, mechanische oder äquivalente Aktuatoren reguliert wird, welche wiederum von einer zentralen Steuereinheit für die gesamte Vorrichtung (10) gesteuert werden.

6. Vorrichtung nach einem oder mehreren der vorhergehenden Ansprüche, **dadurch gekennzeichnet, dass** das erste Führungselement (20) zwei zweite obere Verschlüsse (30) hat, von denen jeder an einem Teil der Ventilationsmittel angeordnet ist, welche innerhalb des ersten Führungselements (20) angeordnet sind.

7. Vorrichtung nach einem oder mehreren der vorhergehenden Ansprüche, **dadurch gekennzeichnet, dass** die Ventilationsmittel durch ein Paar Notfallgebläse (31) gebildet sind.

8. Vorrichtung nach einem oder mehreren der vorhergehenden Ansprüche, **dadurch gekennzeichnet, dass** die zweiten oberen Verschlüsse (30) aus metallischem oder Kunststoffmaterial oder einem anderen äquivalenten Material hergestellt sind.

9. Vorrichtung nach einem oder mehreren der vorhergehenden Ansprüche, **dadurch gekennzeichnet, dass** die zweiten Verschlüsse (30) wahlweise per Motor oder durch Schwerkraft betätigt werden.

10. Vorrichtung nach einem oder mehreren der vorhergehenden Ansprüche, **dadurch gekennzeichnet, dass** das zweite Führungselement (21) einen dritten unteren Verschluss (32) des per Motor oder durch Schwerkraft betriebenen Typs hat, hergestellt aus Kunststoff- oder metallischem Material.

11. Vorrichtung nach einem oder mehreren der vorhergehenden Ansprüche, **dadurch gekennzeichnet, dass** die oberen Führungselemente (20, 22, 26) jeweils durch eine Luftkammer gebildet sind, welche mit dem benachbarten oberen Führungselement so verbunden ist, um einen Verteiler zum Absaugen der Luft aus dem Inneren des Gehäuses (11) in Richtung auf ein Konditionierungsmodul (24, 25) zu bilden.

12. Vorrichtung nach einem oder mehreren der vorhergehenden Ansprüche, **dadurch gekennzeichnet, dass** die unteren Führungselemente (21, 23, 27) jeweils durch eine Basisplatte gebildet sind, welche auf dem Boden aufliegt und mit einem benachbarten unteren Führungselement mittels eines ersten Verschlusses verbunden ist, wobei die Basisplatten einen zusätzlichen Verteiler zum Einleiten konditionierter Luft aus dem aktiven Konditionierungsmodul in das Gehäuse (11) bilden.

13. Vorrichtung nach einem oder mehreren der vorhergehenden Ansprüche, **dadurch gekennzeichnet, dass** sie N Gestelle und N+1 Konditionierungsmodule aufweist.

14. Vorrichtung nach einem oder mehreren der vorhergehenden Ansprüche, **dadurch gekennzeichnet, dass** sie zwei Gestellgehäuse (111a, 111b) und drei Konditionierungsmodule, ein erstes mittleres (124), und ein zweites (125) und ein drittes (136) aufweist, welche extern sind.

15. Vorrichtung nach Anspruch 14, **dadurch gekennzeichnet, dass** die Basisplatte (127) des zweiten externen Konditionierungsmoduls (125) einen einzelnen ersten Verschluss (129) hat.

16. Vorrichtung nach den Ansprüchen 14 und 15, **dadurch gekennzeichnet, dass** die Basisplatte (123) des ersten mittleren Konditionierungsmoduls (124) mit zwei ersten Verschlüssen (128, 137), jede zum Einstellen des Luftdurchgangs alternativ in Richtung der einen oder der anderen benachbarten Basisplatte (121a, 121b) der angrenzenden Gehäuse (111a, 111b), versehen ist.

17. Vorrichtung nach einem oder mehreren der Ansprüche 14 bis 16, **dadurch gekennzeichnet, dass** die Basisplatte (138) des dritten Konditionierungsmoduls (136) einen einzelnen ersten Verschluss (139) hat.

18. Vorrichtung nach einem oder mehreren der vorhergehenden Ansprüche, **dadurch gekennzeichnet, dass** die Notfallgebläse (131a, 131b) durch unterbrechungsfreie Stromversorgungen angetrieben werden, welche in Bezug auf das Gestell intern oder extern sind, um so die Vorrichtung (110) von jeglichen Stromausfällen unabhängig zu machen.

## Revendications

1. Dispositif de climatisation pour baies pour instruments électriques, électroniques et de télécommunications ou analogues, du type comportant au moins une armoire (11) constituée d'au moins une porte (12) pour accéder à l'intérieur de celle-ci, de deux parois latérales (13, 14) et d'une paroi arrière (15), et à l'intérieur de laquelle se trouve un châssis (16) de baies servant à supporter des dispositifs électroniques et analogues (17), des intervalles (18, 19) de passage d'air étant ménagés entre ladite au moins une porte (12) et ledit châssis (16) de casiers et entre ladite paroi arrière (15) et ledit châssis (16) de baie, ladite armoire (11) débouchant, dans une zone supérieure, sur un premier élément de circulation d'air (20) et, dans une zone inférieure, sur un deuxième élément de circulation d'air (21), lesdits premier et deuxième éléments (20, 21) étant eux-mêmes respectivement reliés à au moins un troisième (22, 26) et un quatrième (23, 27) éléments de circulation, qui sont disposés au-dessus et au-dessous d'au moins un module de climatisation correspondant (24, 25) latéralement adjacent à ladite armoire (11) et conçu pour extraire de l'air chaud de celle-ci afin d'y injecter de l'air refroidi, ledit dispositif étant **caractérisé en ce qu'**au moins un de deux éléments de circulation adjacents (20, 21, 22, 23, 26, 27) a au moins un premier obturateur (28, 29) conçu pour permettre, moduler ou empêcher la circulation d'air entre lesdits deux éléments de circulation adjacents(20, 21, 22, 23, 26, 27), lesdits premier et deuxième éléments de circulation (20, 21) associés à l'armoire (11) étant pourvus chacun d'aucun d'au moins un deuxième obturateur supérieur (30) et d'au moins un troisième obturateur inférieur avant (32) pour la climatisation de l'armoire intercalée (11) du type à refroidissement libre, au moins un desdits premier et deuxième éléments de circulation (20, 21) étant pourvu de moyens de ventilation pour la circulation forcée de l'air ambiant à l'intérieur de ladite armoire intercalée (11).

2. Dispositif selon la revendication 1, **caractérisé en ce qu'**il comporte un premier module de climatisation (24) et un deuxième module de climatisation (25), latéralement adjacent à l'armoire (11) sur le côté opposé par rapport au premier module (24).

3. Dispositif selon les revendications 1 et 2, **caractérisé en ce que** lesdits premier (20) et deuxième (21) éléments de circulation de ladite armoire (11) sont respectivement reliés à un troisième élément de circulation (22) et à un quatrième élément de circulation (23), qui sont disposés au-dessus et au-dessous d'un premier module de climatisation correspondant (24), ledit deuxième module (25) ayant un cinquième élément de climatisation supérieur (26) et un sixième élément de climatisation inférieur (27), qui sont reliés aux éléments de circulation adjacents (20, 21) de l'armoire (11).

4. Dispositif selon une ou plusieurs des revendications précédentes, **caractérisé en ce que** lesdits éléments de circulation inférieurs (23, 27) des deux modules de climatisation (24, 25) sont pourvus chacun d'un premier obturateur (28, 29) conçu pour permettre, moduler ou empêcher la circulation d'air entre lesdits éléments de circulation (23, 27) et l'élément de circulation inférieur (21) de l'armoire (11).

5. Dispositif selon la revendication 4, **caractérisé en ce que** lesdits premiers obturateurs (28, 29) sont en matière plastique ou métallique et leur configuration, c'est-à-dire leur degré d'ouverture, est géré par des manipulateurs électromécaniques, mécaniques ou équivalents, qui sont eux-mêmes gérés par une unité centrale servant pour tout le dispositif (10).

6. Dispositif selon une ou plusieurs des revendications précédentes, **caractérisé en ce que** ledit premier élément de circulation (20) a deux deuxièmes obturateurs supérieurs (30), dont chacun est conçu comme faisant partie des moyens de ventilation, qui sont disposés dans ledit premier élément de circulation (20).

7. Dispositif selon une ou plusieurs des revendications précédentes, **caractérisé en ce que** lesdits moyens de ventilation sont constitués par une paire de ventilateurs de secours (31).

8. Dispositif selon une ou plusieurs des revendications précédentes, **caractérisé en ce que** lesdits deuxièmes obturateurs supérieurs (30) sont en matière plastique ou métallique ou autre matière équivalente.

9. Dispositif selon une ou plusieurs des revendications précédentes, **caractérisé en ce que** lesdits deuxièmes obturateurs (30) sont, au choix, motorisés ou mus par gravité.

10. Dispositif selon une ou plusieurs des revendications précédentes, **caractérisé en ce que** ledit deuxième élément de circulation (21) à un troisième obturateur inférieur (32) du type motorisé ou mû par gravité, en matière plastique ou métallique.

11. Dispositif selon une ou plusieurs des revendications précédentes, **caractérisé en ce que** lesdits éléments supérieurs de circulation (20, 22, 26) sont constitués chacun par un volume relié à l'élément de circulation supérieur adjacent de manière à former un collecteur pour diriger vers un module de climatisation (24, 25) l'air extrait de l'intérieur de l'armoire (11).

12. Dispositif selon une ou plusieurs des revendications précédentes, **caractérisé en ce que** lesdits éléments de circulation inférieurs (21, 23, 27) sont constitués chacun par un panneau d'assise qui repose au sol et est relié à un élément de circulation inférieur adjacent à l'aide d'un premier obturateur, lesdits panneaux d'assise formant un collecteur supplémentaire pour introduire dans l'armoire (11) de l'air conditionné issu du module de climatisation actif.

13. Dispositif selon une ou plusieurs des revendications précédentes, **caractérisé en ce qu'**il comporte N armoires à baies et N+1 modules de climatisation.

14. Dispositif selon une ou plusieurs des revendications précédentes, **caractérisé en ce qu'**il comporte deux armoires (111a, 111b) à baies et trois modules de climatisation, un premier (124) en position centrale, et un deuxième (125) et un troisième (136) en position extérieure.

15. Dispositif selon la revendication 14, **caractérisé en ce que** le panneau d'assise (127) du deuxième module de climatisation extérieur (125) a un seul premier obturateur (129).

16. Dispositif selon les revendications 14 et 15, **caractérisé en ce que** le panneau d'assise (123) du premier module de climatisation central (124) est pourvu de deux premiers obturateurs (128, 137), chacun pour régler le passage d'air alternativement vers l'un ou l'autre des panneaux d'assise adjacents (121a, 121b) des armoires adjacentes (117a, 111b).

17. Dispositif selon une ou plusieurs des revendications 14 à 16, **caractérisé en ce que** le panneau d'assise (138) du troisième module de climatisation (136) a un seul premier obturateur (139).

18. Dispositif selon une ou plusieurs des revendications précédentes, **caractérisé en ce que** lesdits ventilateurs de secours (131a, 131b) fonctionnent grâce à des sources d'électricité non interruptibles qui sont internes ou externes par rapport à l'armoire à baies afin de rendre le dispositif (110) indépendant de toute coupure de courant.
